(19) Europäisches Patentamt
European Patent Office
Office européen des brevets

(11) Publication number: **0 041 363**
**B1**

(12) **EUROPEAN PATENT SPECIFICATION**

(45) Date of publication of patent specification: **28.09.83**

(51) Int. Cl.³: **H 03 K 3/295**

(21) Application number: **81302350.4**

(22) Date of filing: **28.05.81**

(54) **Schmitt trigger circuit with a hysteresis characteristic.**

(30) Priority: **29.05.80 JP 71804/80**

(43) Date of publication of application:
**09.12.81 Bulletin 81/49**

(45) Publication of the grant of the patent:
**28.09.83 Bulletin 83/39**

(84) Designated Contracting States:
**DE FR GB NL**

(56) References cited:
**US - A - 3 868 517**
**US - A - 4 031 413**

**PATENTS ABSTRACTS OF JAPAN, vol. 3, no. 30, March 13, 1979, pages 21 E 97**

(73) Proprietor: **FUJITSU LIMITED**
**1015, Kamikodanaka Nakahara-ku**
**Kawasaki-shi Kanagawa 211 (JP)**

(72) Inventor: **Enomoto, Hiromu**
**1-15-1225, Kawara-cho, Saiwai-ku**
**Kawasaki-shi, Kanagawa 210 (JP)**
Inventor: **Mitono, Yoshiharu**
**1-14-12, Sakuragaoka**
**Setagaya-ku Tokyo 156 (JP)**
Inventor: **Yasuda, Yasushi**
**92, Ohmaru, Inagi-shi**
**Tokyo 192-02 (JP)**
Inventor: **Imaizumi, Taketo**
**449, Koueki, Sue-cho**
**Kasuya-gun Fukuoka 811-21 (JP)**
Inventor: **Ohta, Hiroshi**
**2646-3, Eda-cho, Midori-ku**
**Yokohama-shi Kanagawa 227 (JP)**

(74) Representative: **Abbott, Leonard Charles et al,**
**GILL JENNINGS & EVERY 53-64 Chancery Lane**
**London WC2A 1HN (GB)**

**EP 0 041 363 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

Schmitt trigger circuit with a hysteresis characteristic

This invention relates to a schmitt trigger circuit in which the input threshold voltages associated with the rise or fall of the output voltages have a hysteresis characteristic, that is, the input threshold voltage ($V_L$) when the input voltage falls from a high level (H) to a low level (L), is lower than the input threshold voltage ($V_H$) when the input voltage rises from a low level to a high level.

A schmitt trigger circuit, having a high input threshold voltage ($V_H$) associated to the rise of the input voltage and a low input threshold voltage ($V_L$) associated with the fall of the input voltage, has advantages of reduced noise sensitivity and of no oscillation near the point of the threshold voltages, due to the hysteresis characteristic of the input threshold voltages, as hereinafter described in detail with respect of conventional schmitt trigger circuits. Therefore, such a schmitt trigger circuit is advantageously used as an input buffer for various logic circuits, such as flip-flops, shift registers, counters, etc., because, the input of the input buffer usually tends to receive noise and is connected to a long bus line along which the input waveform tends to deteriorate.

However, in a conventional circuit, there is a disadvantage of a sudden increase in the input current when the input voltage falls from the high input threshold voltage ($V_H$) to the low input threshold voltage ($V_L$). Because of this sudden increase in the input current, a drive circuit for supplying input current to the input stage of the schmitt trigger circuit must have a capability of drawing a larger current than the usual current.

Accordingly, an object of the present invention is to provide a schmitt trigger circuit having a hysteresis characteristic in which the input current does not greatly increase.

The invention consists in a schmitt trigger circuit having an input-voltage hysteresis characteristic, comprising: an input stage including a first transistor ($T_{11}$) and a load resistor ($R_1$) connected at a node ($N_1$) in series; an output stage including a second transistor ($T_2$ in Fig. 3A or $T_5$ in Fig. 3B) arranged at the input portion of said output stage; a pn junction diode ($D_1$) connected between said node and the base of said second transistor for turning on said second transistor by applying a voltage lower than the voltage at said node by the amount of the voltage drop across said pn junction diode; a third transistor ($T_3$) connected to said pn junction diode ($D_1$) in parallel for providing said input-voltage hysteresis characteristic; and a switching circuit for turning on said third transistor ($T_3$) in response to a turning on of said second transistor; characterized in that: said first transistor is of a multi-emitter type comprising a first emitter ($E_1$) being connected to said load resistor ($R_1$), and a second emitter ($E_2$) being connected to the base of said second transistor.

The multi-emitter transistor, whose second emitter is connected to the base of the second transistor, draws charges from the base of the second transistor in order to speed up the fall time of an output voltage ($V_o$), but has the advantage, over the schottky barrier diode previously used in such circuits, of limiting the current drawn from the input.

The foregoing object and other objects as well as the characteristic features of the invention will become more apparent and more readily understandable from the following description when read in conjunction with the accompanying drawings, in which like reference characters designate the same or similar parts throughout the figures thereof and wherein:

Fig. 1A is a circuit diagram illustrating a conventional schmitt trigger circuit;

Fig. 1B is a circuit diagram illustrating another conventional schmitt trigger circuit;

Fig. 2A is a graph illustrating the input-output voltage characteristic and the input voltage-input current characteristic in the circuit of Fig. 1A;

Fig. 2B is a graph illustrating the input-output voltage characteristic and the input voltage-input current characteristic in the circuit of Fig. 1B;

Fig. 3A is a circuit diagram illustrating a schmitt trigger circuit according to an embodiment of the present invention;

Fig. 3B is a circuit diagram illustrating a schmitt trigger circuit according to another embodiment of the present invention;

Fig. 4A and 4B are graphs illustrating the input-output voltage characteristics and the input voltage-input current characteristics in the circuits of Fig. 3A and 3B, respectively;

Fig. 5A is a plan view of the structure of the input stage of the conventional schmitt trigger circuit of Fig. 1A or 1B;

Fig. 5B is a cross-sectional view of the structure of the input stage taken along the line $V_b$—$V_b'$ of Fig. 5A;

Fig. 5C is a cross-sectional view taken along the line $V_c$—$V_c'$ of Fig. 5A;

Fig. 6A is a plan view of the structure of the input stage of the schmitt trigger circuit of Fig. 3A or 3B; and

Fig. 6B is a cross-sectional view taken along the line VI—VI' of Fig. 6A.

Before describing the embodiments of the present invention, two examples of conventional schmitt trigger circuits will first be explained with reference to Figs. 1A, 1B, 2A and 2B.

Fig. 1A is a circuit diagram illustrating an example of a conventional schmitt trigger circuit of a true type, in which a low level and a high level of the input voltage correspond to the low level and the high level of the output voltage, respectively. Referring to Fig. 1A, an input stage consists of a pnp transistor $T_1$ and a load resistor $R_1$ connected between the emitter of the transistor $T_1$ and a power supply $V_{cc}$. An output stage consists of npn transistors $T_2$, $T_5$ and $T_6$, load resistors $R_3$ and $R_4$ connected between the power supply $V_{cc}$ and the collectors of the transistors $T_2$ and $T_5$, respectively, a bias transistor $D_2$ connected between the emitter of the transistor $T_2$ and the ground, and a bias resistor $R_5$ connected between the emitter of the transistor $T_5$ and the ground. A schottky barrier diode $D_s$ is connected in the forward direction between the base of the transistor $T_1$ and the base of the transistor $T_2$, for drawing charges on the base of the transistor $T_2$, or, in other words, for the speeding up of the falling time of an output voltage $V_0$. An npn transistor $T_3$ for providing a hysteresis characteristic and an npn transistor $T_4$ for controlling the transistor $T_3$ are disposed between the input stage and the output stage. That is, the collector of the transistor $T_3$ is connected to a node $N_1$ between the resistor $R_1$ and the emitter of the transistor $T_1$. The emitter of the transistor $T_3$ is connected to the base of the transistor $T_2$. The base of the transistor $T_3$ is connected to the collector of the transistor $T_4$. The base of the transistor $T_4$ is connected through a load resistor $R_2$ to the power supply $V_{cc}$. The emitter of the transistor $T_4$ is connected to a node $N_2$ between the resistor $R_4$ and the collector of the transistor $T_5$. The transistors $T_2$ through $T_6$ are schottky barrier diode (SBD) clamping types in this example. Further, a transistor $D_1$ for determining a threshold voltage $V_H$ is connected in parallel to the transistor $T_3$. That is, the base and the collector of the transistor $D_1$ are short-circuited and are connected to the collector of the transistor $T_3$. Also, the emitter of the transistor $D_1$ is connected to the emitter of the transistor $T_3$. The transistors $D_1$ and $D_2$ are used as pn junction diodes by connecting the bases to the collectors, respectively.

In operation, the base of the transistor $T_1$ receives an input voltage $V_{IN}$. When the input voltage $V_{IN}$ is low (hereinafter referred to L) of, for example, 0V, the transistor $T_1$ is in an ON state so that a current $I_1$ flows through the resistor $R_1$. During this state, the potential at the node $N_1$ is higher than the potential $V_{IN}$ by the amount of only the base-emitter voltage $V_{BE}$ of the transistor $T_1$. Therefore, the transistor $T_2$ is at an OFF state. In order to turn on the transistor $T_2$, the potential at the node $N_1$ must be higher than the sum of the base-emitter voltages of the transistor $D_1$, $T_2$ and $D_2$, i.e., higher than $3V_{BE}$. For this purpose, the input voltage $V_{IN}$ must be higher than $2V_{BE}$, because the potential of the base of the transistor $T_1$ is lower than the potential at the node $N_1$ by the amount of the base-emitter voltage $V_{BE}$. When the input voltage $V_{IN}$ becomes L to turn off the transistor $T_2$, the potential at the base of the transistor $T_5$ becomes high to turn it on. Therefore, a current $I_2$ flows through the resistor $R_2$, the transistor $T_4$, the transistor $T_5$ and the resistor $R_5$ so that the potential at the base of the transistor $T_6$ becomes high to turn it on. As a result, the output voltage $V_o$ of this schmitt trigger circuit becomes L. In this state, a current $I_4$ does not conduct from the base of the transistor $T_4$ to the base of the transistor $T_3$. It should be noted that, in the actual operation, a pull up circuit (not shown), for raising the output voltage $V_o$ when the transistor $T_6$ is in an OFF state, is connected between the power supply $V_{cc}$ and the collector of the transistor $T_6$. The pull up circuit may be a resistor or an active pull up circuit which conducts a current only when the output voltage $V_o$ switches.

When the input voltage $V_{IN}$ is raised from L to a value higher than $2V_{BE}$, the transistor $T_2$ begins to be turned on at the time when the input voltage $V_{IN}$ reaches $2V_{BE}$, because a base current $I_3$ is supplied from the power supply $V_{cc}$ through the resistor $R_1$, the node $N_1$, and the transistor $D_1$ to the base of the transistor $T_2$. When the transistor $T_2$ begins to turn on, the base current of the transistor $T_5$ decreases to turn off the transistor $T_5$, and accordingly to turn off the transistor $T_6$. As a result, the current $I_2$ flowing through the resistor $R_2$, the transistor $T_4$ and the transistor $T_5$ becomes zero, and alternately, a current $I_4$ begins to flow through the base and collector of the transistor $T_4$. The current $I_4$ is supplied to the base of the transistor $T_3$ to turn it on. During this period the transistor $T_3$ is on, because the collector-emitter voltage $V_{CE}$ of the transistor $T_3$ is smaller than the base-emitter voltage $V_{BE}$ of the transistor $D_1$, a base current $I_5$ flowing through the resistor $R_1$, the node $N_1$, and the transistor $T_3$ is supplied to the base of the transistor $T_2$. Since the transistors $T_5$ and $T_6$ are turned off, the output voltage $V_o$ becomes a high voltage (hereinafter referred to H).

In order to turn off the transistor $T_2$ when the input voltage $V_{IN}$ changes from H to L, the potential at the node $N_1$ must be lower than $V_{CE}+2V_{BE}$, which is the sum of the collector-emitter voltage $V_{CE}$ of the transistor $T_3$ and the two base-emitter voltages $2V_{BE}$ of the transistors $T_2$ and $D_2$. Therefore, the low input threshold voltage $V_L$ of the input voltage $V_{IN}$ for changing the output voltage $V_o$ from H to L when the input voltage $V_{IN}$ falls from H to L is equal to $V_{BE}+V_{CE}$, while, the high input threshold voltage $V_H$, for changing the output voltage $V_o$ from L to H when the input voltage $V_{IN}$ rises from L to H, is equal to $2V_{BE}$, as mentioned before. Accordingly, this schmitt trigger circuit has input threshold voltages with hysteresis characteristic.

Fig. 2A illustrates the hysteresis characteristic of the input threshold voltages. Referring to the upper portion of Fig. 2A, when the input voltage $V_{IN}$ rises to reach the high input threshold voltage $V_H$ equal to $2V_{BE}$, the output voltage $V_o$ turns from L to H. In contrast, when the input voltage $V_{IN}$ falls from H to the low input threshold voltage $V_L$ equal to $V_{BE}+V_{CE}$, the output voltage $V_o$ turns from H to L. The difference between the high input threshold voltage $V_H$ and the low input threshold voltage $V_L$ is, as illustrated in Fig. 2A, equal to $V_{BE}—V_{CE}$. Usually, the base-emitter voltage $V_{BE}$ is approximately equal to 0.8V, and the collector-emitter voltage $V_{CE}$ is approximately equal to 0.2 through 0.3V. Therefore, the difference between the $V_H$ and the $V_L$ is at least 0.4V. Because of this difference in the input threshold voltages, the schmitt trigger circuit of Fig. 1A has advantages of reduced noise sensitivity and of no oscillation near the point of the threshold voltages, when compared with a schmitt trigger circuit having a fixed input threshold voltage regardless of the rising or falling of the input voltage.

However, in the circuit of Fig. 1A, because of the schottky barrier diode $D_s$ for drawing charges on the base of the transistor $T_2$, there is a disadvantage that a large current $I_6$ flows from the power supply $V_{cc}$ through the transistor $T_3$ and the diode $D_s$ to the input when the input voltage falls from H to L, as illustrated in the lower portion of Fig. 2A. More precisely, because the current path through the diode $D_s$ to the input is parallel to the current path from the base of the transistor $T_2$ through the transistor $D_2$ to the ground, the current $I_6$ begins to flow when the input voltage $V_{IN}$ falls so that the sum of the input voltage $V_{IN}$ and a voltage drop $V_F$ across the diode $D_s$ approaches $2V_{BE}$ which is equal to the sum of the base-emitter voltages of the transistors $T_2$ and $D_2$. For example, when the sum of the $V_{IN}$ and $V_F$ is equal to $2V_{BE}$, then, the base current $I_5$ is equal to the current $I_6$. As a result, the base current $I_{IL}$ flowing through the base of the transistor $T_1$ is suddenly but temporarily increased as the input voltage $V_{IN}$ falls from $V_H$ to $V_L$, as illustrated in the lower portion of Fig. 2A. When the input voltage $V_{IN}$ is lowered to a value immediately above the low input threshold voltage $V_L$, the input current $I_{IL}$ reaches a maximum value. Then, when the input voltage $V_{IN}$ reaches the $V_L$, the transistor $T_1$ is turned on. In this state, the current $I_4$ does not flow as hereinbefore described, and thus the transistor $T_3$ is turned off. Therefore, the current $I_6$ becomes zero. The input current $I_{IL}$ then is reduced to the $I_1/\beta$, where $\beta$ is the current amplification factor of the transistor $T_1$ usually having a value on the order of 20 to 30.

The characteristic feature of a schmitt trigger circuit employing a pnp transistor at its input stage such as shown in Fig. 1A is its low input current. Therefore, the schmitt trigger circuit can be driven by using a low current source, such as a CMOS circuit. However, because of the sudden increase in the input current $I_{IL}$ as described above, the current source (not shown), which is to be connected to the input of the schmitt trigger circuit of Fig. 1A, must be capable of drawing a large current. The CMOS drive circuit can not draw such a large current. Moreover, if a current source is to be connected to a plurality of schmitt trigger circuits, the problem of not being capable of drawing such a large current becomes more serious.

The problem of conducting a large input current also occurs in a conventional inverted-type schmitt trigger circuit, an example of which is illustrated in Fig. 1B. The difference between the circuits of Fig. 1A and 1B is that, instead of connecting a circuit comprised of the resistors $R_2$ and $R_3$, and the transistors $T_2$, $T_4$ and $D_2$ in the circuit of Fig. 1A, a circuit comprised of resistors $R_6$ and $R_7$, and npn transistors $T_7$, $T_8$ and $D_3$ is connected between the input stage and the output stage in Fig. 1B. The resistor $R_6$ is connected between the power supply $V_{cc}$ and the collector of the transistor $T_7$. The base of the transistor $T_3$ is also connected to the collector of the transistor $T_7$. The resistor $R_7$ is connected between the power supply $V_{cc}$ and the base of the transistor $T_8$. The collector of the transistor $T_8$ is connected to the base of the transistor $T_7$. The emitter of the transistor $T_8$ is connected to the collector of the transistor $T_5$. The emitter of the transistor $T_7$ is connected to the collector and the base of the transistor $D_3$. The emitter of the transistor $D_3$ is connected to the ground.

The upper portion of Fig. 2B illustrates the hysteresis characteristic of the input threshold voltages of the circuit of Fig. 1B. In operation of the circuit of Fig. 1B, when the input voltage falls from H to L, the transistor $T_1$ turns on when the input voltage $V_{IN}$ becomes lower than the low input threshold voltage $V_L$. When the transistor $T_1$ is in the ON state, the transistor $T_5$ is not supplied with its base current because the potential at the node $N_1$ is too low. Therefore, the transistor $T_5$ and accordingly the transistor $T_6$ are in their OFF states so that the output voltage $V_o$ is H. In contrast, when the input voltage $V_{IN}$ rises from L to H, the transistor $T_1$ turns off when the input voltage $V_{IN}$ becomes higher than the high input threshold voltage $V_H$. When the transistor $T_1$ is in the OFF state, the transistors $T_5$ and $T_6$ are in their ON states so that the output voltage $V_o$ is L. The transistor $T_3$ is in an OFF state when the input voltage $V_{IN}$ is L, because the transistor $T_5$ is in its OFF state so that the potential at the node $N_2$ is equal to the $V_{cc}$, and accordingly, a current flows through the resistor $R_7$ and the base-collector of the transistor $T_8$ to provide a base current to the transistor $T_7$ to turn it on. Therefore, the transistor $T_3$ does not receive a base current when the input voltage $V_{IN}$ is L. In contrast, when the input voltage $V_{IN}$ is H, the transistor $T_3$ is in an ON state because the transistor $T_5$ is in an ON state so that the potential at the node $N_2$ is decreased. Therefore, a current conducts through the base-emitter of the transistor $T_8$, the transistor $T_5$ and the resistor $R_5$.

Accordingly, the transistor $T_7$ does not receive the base current. As a result, the transistor $T_3$ receives its base current from the power supply $V_{cc}$ through the resistor $R_6$, when the input voltage $V_{IN}$ is H. Similarly to the circuit of Fig. 1A, the current $I_6$ flowing through the transistor $T_3$ and the diode $D_s$ is also generated in the circuit of Fig. 1B when the input voltage $V_{IN}$ falls from H to L, as illustrated in the lower portion of Fig. 2B.

According to the present invention, instead of the schottky barrier diode $D_s$ used in the conventional circuit of Fig. 1A or Fig. 1B, a multi-emitter transistor is employed for suppressing such a large input current during the falling of the input voltage. Embodiments of the present invention will now be described.

Fig. 3A is a circuit diagram illustrating a schmitt trigger circuit according to one embodiment of the present invention. The circuit of Fig. 3A is of a true type in which the L level and the H level of the input voltage $V_{IN}$ correspond to the L level and the H level of the output voltage $V_o$, respectively. The difference between the conventional circuit shown in Fig. 1A and the circuit shown in Fig. 3A is that, the schottky barrier diode $D_s$ used in the circuit of Fig. 1A is not employed in the circuit of Fig. 3A, and instead of the pnp transistor $T_1$, a multi-emitter pnp transistor $T_{11}$ is employed in Fig. 3A. The first emitter $E_1$ of the transistor $T_{11}$ is connected to the load resistor $R_1$. The second emitter $E_2$ of the transistor $T_{11}$ is connected to the base of the transistor $T_2$ as well as to the emitters of the transistors $D_1$ and $T_3$. By this construction, the multi-emitter transistor $T_{11}$ not only operates in a way similar to the transistor $T_1$ in Fig. 1A, but also operates to solve the problem caused by the circuit of Fig. 1A.

The operation of the circuit of Fig. 3A will now be described with reference to Fig. 4A, which is a graph illustrating the input-output voltage characteristic and the input voltage-input current characteristic. Referring to the upper portion of Fig. 4A, the hysteresis characteristic of the input threshold voltage is the same as that illustrated in Fig. 2A for the conventional circuit of Fig. 1A, because a first transistor $T_a$ of the multi-emitter transistor $T_{11}$ consisting of the first emitter $E_1$, the base and the collector operates in the same way as the transistor $T_1$ in the circuit of Fig. 1A. However, as can be seen from the lower portion of Fig. 4A, a sudden increase in the input current $I_{IN}$ is not generated while the input voltage $V_{IN}$ falls from H to L. That is, during the period the input voltage is falling from the $V_H$ to the $V_L$, the transistor $T_a$ begins to turn on. Therefore, the potential at the node $N_1$ is higher than the input voltage $V_{IN}$ by the amount of the voltage $V_{BE}$ between the base and the first emitter $E_1$ of the transistor $T_a$. While, if a current such as the current $I_6$ in Fig. 1A could flow through the transistor $T_3$ and the second emitter $E_2$ to the base of a second transistor $T_b$ which consists of the second emitter $E_2$, the base and the collector of the transistor $T_{11}$, the voltage drop between the collector of the transistor $T_3$ and the base of the transistor $T_{11}$ would be equal to the sum of $V_{CE}$ and $V_{BE}'$, where $V_{BE}'$ is the base-second emitter $E_2$ voltage of the transistor $T_b$. Since $V_{BE}'$ is nearly equal to $V_{BE}$, $V_{BE}'+V_{CE}$ is greater than $V_{BE}$. Therefore, the current path through the transistor $T_3$ and the second emitter $E_2$ to the base can not substantially exist during this period. As a result, the input current $I_{IN}$ is equal to $I_1/\beta_a$, where $\beta_a$ is the current amplification factor of the transistor $T_a$. If a current flows through the transistor $T_b$ in a transient state of the transistor $T_{11}$, the current will be decreased by a factor of $\beta_b$, where $\beta_b$ is the current amplification factor of the transistor $T_b$, and nearly equal to $\beta_a$. In either case, $I_{IL}$ is substantially equal to $I_1/\beta_a$.

Further, the transistor $T_b$ in the multi-emitter transistor $T_{11}$ acts to draw charges from the base of the transistor $T_2$, for the speeding up of the operation when the input voltage falls, to the ground, as the schottky barrier diode $D_s$ did in the circuit of Fig. 1A. That is, when the input voltage $V_{IN}$ falls to a value lower than the low input threshold voltage $V_L$, the transistor $T_b$ is completely turned on so that charges on the base of the transistor $T_2$ are drawn to the second emitter $E_2$ as a current $I_7$. By the current ampification factor $\beta_b$ of the transistor $T_b$, the current $I_7$ is reduced to $I_7/\beta_b$ at the base of the transistor $T_b$.

Fig. 3B is a circuit diagram illustrating a schmitt trigger circuit according to another embodiment of the present invention. The circuit of Fig. 3B is of an inverted type in which the L level and the H level of the input voltage $V_{IN}$ correspond to the H level and the L level of the output voltage $V_o$, respectively. Referring to Fig. 3B, the multi-emitter transistor $T_{11}$ is also employed. The other portion is the same as the corresponding portion in the conventional circuit of Fig. 1B. The operation of the circuit of Fig. 3B may be easily understood by those skilled in the art from the foregoing description and by referring to Fig. 4B, which is a graph illustrating the input-output voltage characteristic and the input voltage-input current characteristic in the circuit of Fig. 3B. Therefore, further description with respect to the circuit of Fig. 4B is not provided here.

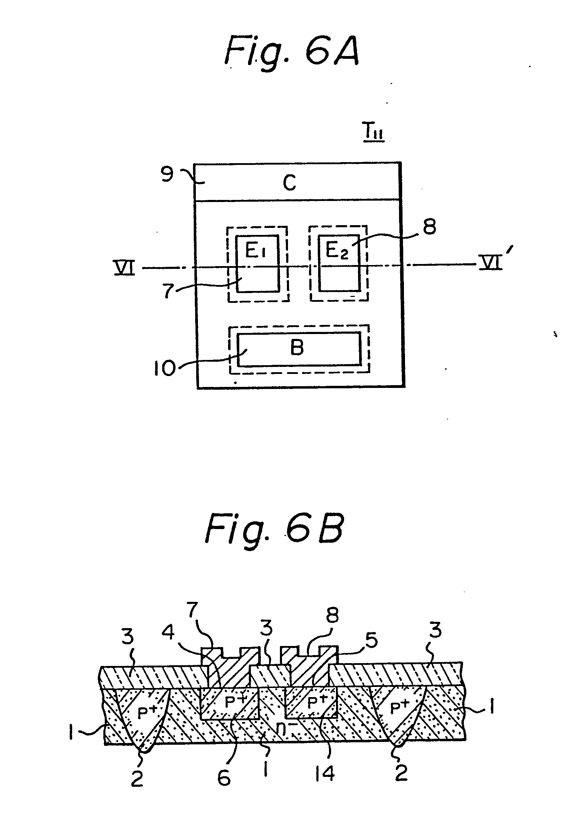

The multi-emitter transistor $T_{11}$ can easily be integrated with the other elements on a semiconductor substrate without serious design alternation of the conventional schmitt trigger circuit of Fig. 1A or 1B. This will be easily understood from the following description with reference to Figs. 5A, 5B, 5C, 6A and 6B. Fig. 5A is a plan view of the structure of the transistor $T_1$ and the schottky barrier diode $D_s$ illustrated in the conventional schmitt trigger circuit of Fig. 1A or 1B. Figs. 5B and 5C are cross-sectional views taken along the lines $V_b$—$V_b'$ and $V_c$—$V_c'$ of Fig. 5A. Referring to Fig.

5A, the electrodes 9, 7, and 13 of the collector C, the emitter E and the base B of the transistor $T_1$, respectively, and the anode electrode 8 of the schottky barrier diode $D_s$ are disposed on a surface of an insulating layer 3. Referring to Fig. 5B, in an $n^-$-type epitaxial layer 1, $p^+$-type isolation region 2 is formed for electrically separating the transistor $T_1$ and the diode $D_s$ from the other elements on the schmitt trigger circuit. On the $n^-$-type epitaxial layer 1 and the isolation region 2, the insulation layer 3 of, for example, $SiO_2$, is formed. A window 4 for forming the emitter E of the transistor $T_1$ and a window 5 for forming the schottky barrier of the diode $D_s$ is provided in the insulation layer 3. A $p^+$-type diffusion region 6 is formed by diffusing $p^+$-type impurity atoms through the window 4. On the window 4, an aluminum electrode 7 for the emitter E of the transistor $T_1$ is formed. On the window 5, an aluminum electrode 8 for the anode of the diode $D_s$ is formed. The schottky barrier of the diode $D_s$ is formed by the contact of the aluminum layer 8 to the $n^-$-type epitaxial layer 1. Referring to Fig. 5C, an aluminum electrode 9 for the collector C is formed on a window 10 which makes an electrical contact joining the $p^+$-type region 2 to the aluminum electrode 9. An $n^+$-type diffusion region 11 for the base contact is formed by diffusing $n^+$-type impurity atoms through a window 12. On the window 12, an aluminum electrode 13 is formed to be the base electrode.

Fig. 6A is a plan view of the structure of the multi-emitter transistor $T_{11}$ illustrated in Fig. 3A or 3B. Fig. 6B is a cross-sectional view taken along the line VI—VI′ of Fig. 6A. The only difference between the structures of the conventional circuit illustrated in Figs. 5A through 5C and of the embodiment of the present invention illustrated in Fig. 6A and 6B is that, in Fig. 6B, a $p^+$-type diffusion region 14 is formed by diffusing $p^+$-type impurity atoms through the window 5. The region 14 acts as the second emitter $E_2$. While the region 6 acts as the first emitter $E_1$. Because no additional process step is required for forming the $p^+$-type region 14, the multi-emitter transistor $T_{11}$ can easily be integrated with the other elements of the schmitt trigger circuit.

Instead of forming the multi-emitter transistor $T_{11}$, a capacitor or a pn junction diode could in theory be formed in place of the schottky barrier diode $D_s$. However, if a capacitor or a pn junction diode were formed for suppressing the sudden increase in the input current, additional steps of, for example, forming isolation regions, would be required so that the manufacturing steps would become complicated and the chip area would be increased. Therefore, in view of the circuit integration, the multi-emitter transistor used in the invention has a distinct advantage over the capacitor or the pn junction diode.

From the foregoing description, it will be apparent that, in a schmitt trigger circuit having input threshold voltages with a hysteresis characteristic for reducing input noise sensitivity and for preventing an oscillation at a point near the threshold voltages, according to the present invention, a sudden increase in the input current during falling of the input voltage is greatly suppressed by employing a multi-emitter transistor in the input stage of the schmitt-trigger circuit.

It will be apparent that the present invention is not restricted to the illustrated embodiments but various changes and modifications are possible without departing from the basic scope of the invention. For example, although the transistors $T_2$ through $T_8$ are of schottky barrier clamping type in the foregoing embodiments, these transistors may be of any bipolar type. Also, although no buried layer is illustrated in the structure of the conventional schmitt trigger circuit, a buried layer is usually formed for reducing a DC resistance of the diode $D_s$. The structure of the schmitt trigger circuit according to the present invention may of course include a buried layer.

**Claims**

1. A schmitt trigger circuit having an input-voltage hysteresis characteristic, comprising:

an input stage including a first transistor ($T_{11}$) and a load resistor ($R_1$) connected at a node ($N_1$) in series;
an output stage including a second transistor ($T_2$ in Fig. 3A or $T_5$ in Fig. 3B) arranged at the input portion of said output stage;
a pn junction diode ($D_1$) connected between said node and the base of said second transistor for turning on said second transistor by applying a voltage lower than the voltage at said node by the amount of the voltage drop across said pn junction diode;
a third transistor ($T_3$) connected to said pn junction diode ($D_1$) in parallel for providing said input-voltage hysteresis characteristic; and
a switching circuit for turning on said third transistor ($T_3$) in response to a turning on of said second transistor;

characterised in that:

said first transistor is of a multi-emitter type comprising a first emitter ($E_1$) and a second emitter ($E_2$), said first emitter ($E_1$) being connected to said load resistor ($R_1$), and said second emitter ($E_2$) being connected to the base of said second transistor.

2. A schmitt trigger circuit as set forth in Claim 1, wherein, said first transistor ($T_{11}$) is of a pnp type further comprising a base for receiving an input voltage of the schmitt trigger circuit, and a collector connected to the ground.

3. A schmitt trigger circuit as set forth in Claim 2, wherein said load resistor is connected between a power supply and said first emitter.

4. A schmitt trigger circuit as set forth in Claim 3, wherein, said pn junction diode ($D_1$) comprises an npn transistor in which the base and the collector are short-circuited and are connected to said node ($N_1$); the collector of said third transistor is connected to the collector of said npn transistor; and the emitters of said npn transistor ($D_1$) and said third transistor ($T_3$) are connected together to said second emitter ($E_2$) of said multi-emitter transistor ($T_{11}$).

5. A schmitt trigger circuit as set forth in Claim 4, wherein said second and third transistors are of an npn type.

6. A schmitt trigger circuit as set forth in Claim 4 or 5, wherein, said second and third transistors are of schottky barrier clamping type.

7. A schmitt trigger circuit as set forth in Claim 5 or 6, wherein said switching circuit comprises a fourth npn transistor ($T_4$) having a base connected through a second load resistor ($R_2$ in Fig. 3A) to said power supply, and a collector connected to the base of said third transistor.

8. A schmitt trigger circuit as set forth in Claim 7, wherein, said second transistor further comprises a collector connected through a third load resistor ($R_3$) to said power supply, and an emitter connected through a second pn junction diode ($D_2$) to the ground.

9. A schmitt trigger circuit as set forth in Claim 7, wherein, said output stage further comprises a fifth npn transistor ($T_5$ in Fig. 3A) having a base connected to the collector of said second transistor ($T_2$), a collector connected to the emitter of said fourth transistor and to said power supply through a fourth resistor ($R_4$), and an emitter connected through a bias resistor ($R_5$) to the ground.

10. A schmitt trigger circuit as set forth in Claim 9, wherein, said output stage further comprises a sixth npn transistor ($T_6$ in Fig. 3A) having a base connected to the emitter of said fifth transistor, a collector connected to an output terminal of said schmitt trigger circuit, and an emitter connected to the ground.

11. A schmitt trigger circuit as set forth in Claim 5 or 6, wherein, said switching circuit comprises seventh and eighth npn transistors ($T_7$ and $T_8$ in Fig. 3B), the collector of said seventh transistor ($T_7$) being connected to the base of said third transistor ($T_3$) and through a load resistor ($R_6$) to said power supply, the base of said seventh transistor ($T_7$) being connected to the collector of said eighth transistor ($T_8$), the emitter of said seventh transistor ($T_7$) being connected through a second pn junction diode ($D_3$) to the ground, the base of said eighth transistor ($T_8$) being connected through a load resistor ($R_7$) to said power supply, and the emitter of said eighth transistor being connected to the collector of said second transistor ($T_5$ in Fig. 3B).

12. A schmitt trigger circuit as set forth in Claim 11, wherein said second transistor ($T_5$ in Fig. 3B) further comprises a collector connected through a fourth load resistor ($R_4$) to said power supply, and an emitter connected through a bias resistor ($R_5$) to the ground.

13. A schmitt trigger circuit as set forth in Claim 12, wherein, said output stage further comprises a sixth npn transistor ($T_6$ in Fig. 3B) having a base connected to the emitter of said second transistor ($T_5$ in Fig. 3B), a collector connected to an output terminal of said schmitt trigger circuit, and an emitter connected to the ground.

**Revendications**

1. Circuit basculeur de Schmitt possédant une caractéristique d'hystérésis de sa tension d'entrée, comprenant:

un étage d'entrée comportant un premier transistor ($T_{11}$) et une résistance de charge ($R_1$) connectés à un noeud ($N_4$) en série;

un étage de sortie comportant un deuxième transistor ($T_2$ sur la figure 3A ou $T_5$ sur la figure 3B) placé à la partie d'entrée dudit étage de sortie;

une diode à jonction pn ($D_1$ connectée entre ledit roeud et la base dudit deuxième transistor afin de rendre conducteur ledit deuxième transistor per application d'une tension inférieure à la tension existant sur ledit noeud, d'une quantité correspondant à la chute de tension aux bornes de ladite diode à jonction pn;

un troisième transistor ($T_3$) connecté à ladite diode à jonction pn ($T_1$) en parallèle afin d'assurer ladite caractéristique d'hystérésis de la tension d'entrée; et

un circuit de commutation destiné à rendre conducteur ledit troisième transistor ($T_3$) en réponse à un passage à l'état conducteur dudit deuxième transistor;

caractérisé en ce que:

ledit premier transistor est d'un type multi-émetteur comprenant un premier émetteur ($E_1$) et un deuxième émetteur ($E_2$) le premier émetteur ($E_1$) étant connecté à ladite résistance de charge ($R_1$), et ledit deuxième émetteur ($E_2$) étant connecté à la base dudit deuxième transistor.

2. Circuit basculeur de Schmitt selon la revendication 1, où ledit premier transistor ($T_{11}$) est d'un type pnp comprenant en outre une base destinée à recevoir une tension d'entrée du circuit basculeur de Schmitt et un collecteur connecté à la terre.

3. Circuit basculeur de Schmitt selon la revendication 2, où ladite résistance de charge est connectée entre une alimentation électrique et ledit premier émetteur.

4. Circuit basculeur de Schmitt selon la revendication 3, où ladite diode à jonction pn ($D_1$) comprend un transistor npn dans lequel la base et le collecteur sont en court-circuit et sont connectés audit noeud ($N_1$); le collecteur dudit troisième transistor est connecté au collecteur dudit transistor npn; et les émetteurs dudit transistor npn ($D_1$) et dudit troisième transistor ($T_3$) sont connectés ensemble audit deuxième émetteur ($E_2$) dudit transistor multi-émetteur ($T_{11}$).

5. Circuit basculeur de Schmitt selon la revendication 4, où lesdits deuxième et troisième transistors sont d'un type npn.

6. Circuit basculeur de Schmitt selon la revendication 4 ou 5, où lesdits deuxième et troisième transistors sont de type verrouillage à barrière de Schottky.

7. Circuit basculeur de Schmitt selon la revendication 5 ou 6, où ledit circuit de commutation comprend un quatrième transistor npn ($T_4$) possédant une base connectée à ladite alimentation électrique par l'intermédiaire d'une deuxième résistance de charge ($R_2$ sur la figure 3A) et un collecteur connecté à la base dudit troisième transistor.

8. Circuit basculeur de Schmitt selon la revendication 7, où ledit deuxième transistor comprend en outre un collecteur connecté à ladite alimentation électrique par l'intermédiaire d'une troisième résistance de charge ($R_3$) et un émetteur connecté à la terre par l'intermédiaire d'une deuxième diode à jonction pn ($D_2$).

9. Circuit basculeur de Schmitt selon la revendication 7, où ledit étage de sortie comprend en outre un cinquième transistor npn ($T_5$ sur la figure 3A) possédant une base connectée au collecteur du deuxième transistor ($T_2$), un collecteur connecté à l'émetteur dudit quatrième transistor et à l'alimentation électrique par l'intermédiaire d'une quatrième résistance ($R_4$) et un émetteur connecté à la terre par l'intermédiaire d'une résistance de polarisation ($R_5$).

10. Circuit basculeur de Schmitt selon la revendication 9, où ledit étage de sortie comprend en outre un sixième transistor npn ($T_6$ sur la figure 3A) possédant une base connectée à l'émetteur dudit cinquième transistor, un collecteur connecté à une borne de sortie dudit basculeur de Schmitt, et un émetteur connecté à la terre.

11. Circuit basculeur de Schmitt selon la revendication 5 ou 6, où ledit circuit de commutation comprend un septième et un huitième transistor npn ($T_7$ et $T_8$ sur la figure 3B), le collecteur dudit septième transistor ($T_7$) étant connecté à la base dudit troisième transistor ($T_3$) et, via une résistance de charge ($R_8$), à l'alimentation électrique, la base dudit septième transistor ($T_7$) étant connectée au collecteur dudit huitième transistor ($T_8$), l'émetteur dudit septième transistor ($T_7$) étant connecté à la terre par l'intermédiaire d'une deuxième diode à jonction pn ($D_3$), la base dudit huitième transistor ($T_8$) étant connectée via une résistance de charge ($R_7$) à ladite alimentation électrique, et l'émetteur dudit huitième transistor étant connecté au collecteur dudit deuxième transistor ($T_5$ sur la figure 3B).

12. Circuit basculeur de Schmitt selon la revendication 11, où ledit deuxième transistor ($T_5$ sur la figure 3B) comprend en outre un collecteur connecté via une quatrième résistance de charge ($R_4$) à ladite alimentation électrique, et un émetteur connecté à la terre par l'intermédiaire d'une résistance de polarisation ($R_5$).

13. Circuit basculeur de Schmitt selon la revendication 12, où ledit étage de sortie comprend en outre un sixième transistor npn ($T_6$ sur la figure 3B) possédant une base connectée à l'émetteur dudit deuxième transistor ($T_5$ sur la figure 3B), un collecteur connecté à une borne de sortie dudit circuit basculeur de Schmitt, et un émetteur connecté à la terre.

**Patentansprüche**

1. Schmitt-Trigger-Schaltung mit Eingangsspannungs-Hysterese-Eigenschaft,

mit einer Eingangsstufe, welche einen ersten Transistor ($T_{11}$) und einen Lastwiderstand ($R_1$) umfaßt, welche bei einem Knotenpunkt ($N_1$) in Reihe geschaltet sind, einer Ausgangsstufe, welche einen zweiten Transistor ($T_2$ in Fig. 3A oder $T_5$ in Fig. 3B) umfaßt, der an dem Eingangsabschnitt der genannten Ausgangsstufe angeordnet ist,

einer Diode mit PN-Übergang ($D_1$), welche zwischen dem genannten Knotenpunkt und der Basis des genannten zweiten Transistors geschaltet ist, um den genannten zweiten Transistor durch Zuführung einer Spannung einzuschalten, welche um den Betrag des Spannungsabfalls an der genannten Diode mit PN-Übergang niedriger als die Spannung bei dem genannten Knotenpunkt ist, einem dritten Transistor ($T_3$), welcher mit der genannten Diode mit PN-Übergang ($D_1$) parallel geschaltet ist um die genannte Eingangsspannungs-Hysterese-Eigenschaft zu erzeugen,

und einem Schaltkreis zur Einschaltung des dritten Transistors ($T_3$) in Abhängigkeit von dem Einschalten des genannten zweiten Transistors

dadurch gekennzeichnet,

daß der erste Transistor ein Multiemittertransistor ist, welcher einen ersten Emitter ($E_1$) umfaßt, der mit dem genannten Lastwiderstand ($R_1$) verbunden ist, und einen zweiten Emitter ($E_2$), welcher mit der Basis des genannten zweiten Transistors verbunden ist.

2. Schmitt-Trigger-Schaltung nach Anspruch 1, dadurch gekennzeichnet, daß der erste Transistor ($T_{11}$) vom PNP-Typ ist und eine Basis zum Empfang einer Eingangsspannung der Schmitt-Trigger-Schaltung und einen an Erde liegenden Kollektor umfaßt.

3. Schmitt-Trigger-Schaltung nach Anspruch 2, dadurch gekennzeichnet, daß der Lastwiderstand zwischen der Stromversorgung und dem genannten ersten Emitter liegt.

4. Schmitt-Trigger-Schaltung nach Anspruch 3, dadurch gekennzeichnet, daß die Diode mit PN-Übergang ($D_1$) einen NPN-Transistor umfaßt, bei welchem die Basis und der Kollektor kurzgeschlossen und mit dem genannten Knotenpunkt ($N_1$) verbunden sind, der Kollektor des genannten dritten Transistors mit dem Kollektor des genannten NPN-Transistors verbunden ist, die Emitter des genannten NPN-Transistors ($D_1$) und des genannten dritten Transistors ($T_3$) gemeinsam mit dem zweiten Emitter ($E_2$) des genannten Multiemitter-transistors ($T_{11}$) verbunden sind.

5. Schmitt-Trigger-Schaltung nach Anspruch 4, dadurch gekennzeichnet, daß die zweiten und die dritten Transistoren vom NPN-Typ sind.

6. Schmitt-Trigger-Schaltung nach Anspruch 4 oder 5, dadurch gekennzeichnet, daß der zweite und der dritte Transistor vom Schottky-Sperrschicht-Klemmtyp sind.

7. Schmitt-Trigger-Schaltung nach Anspruch 5 oder 6, dadurch gekennzeichnet, daß der genannte Schaltkreis einen vierten NPN-Transistor ($T_4$) umfaßt, dessen Basis über einen zweiten Lastwiderstand ($R_2$ in Fig. 3A) mit der genannten Stromversorgung und dessen Kollektor mit der Basis des dritten Transistors verbunden sind.

8. Schmitt-Trigger-Schaltung nach Anspruch 7, dadurch gekennzeichnet, daß der zweite Transistor ferner einen Kollektor umfaßt, welcher über einen dritten Lastwiderstand ($R_3$) mit der genannten Stromversorgung verbunden ist, und einen Emitter, welcher über eine zweite Diode mit PN-Übergang ($D_2$) mit Erde verbunden ist.

9. Schmitt-Trigger-Schaltung nach Anspruch 7, dadurch gekennzeichnet, daß die Ausgangsstufe ferner einen fünften NPN-Transistor ($T_5$ in Fig. 3A) umfaßt, dessen Basis mit dem Kollektor des genannten zweiten Transistors ($T_2$), dessen Kollektor mit dem Emitter des genannten vierten Transistors und mit der genannten Stromversorgung über einen vierten Widerstand ($R_4$), und dessen Emitter über einen Vorspannungswiderstand ($R_5$) mit Erde verbunden sind.

10. Schmitt-Trigger-Schaltung nach Anspruch 9, dadurch gekennzeichnet, daß die Ausgangsstufe ferner einen sechsten NPN-Transistor ($T_6$ in Fig. 3A) umfaßt, dessen Basis mit dem Emitter des genannten fünften Transistors, dessen Kollektor mit dem Ausgangsanschluß der genannten Schmitt-Trigger-Schaltung und dessen Emitter mit Erde verbunden ist.

11. Schmitt-Trigger-Schaltung nach Anspruch 5 oder 6, dadurch gekennzeichnet, daß der Schaltkreis einen siebten und einen achten NPN-Transistor ($T_7$ und $T_8$ in Fig. 3B) umfaßt, der Kollektor des siebten Transistors ($T_7$) mit der Basis des genannten dritten Transistors ($T_3$) und über einen Lastwiderstand ($R_6$) mit der genannten Stromversorgung verbunden ist, die Basis des genannten siebten Transistors ($T_7$) mit dem Kollektor des genannten achten Transistors ($T_8$) verbunden ist, der Emitter des genannten siebten Transistors ($T_7$) über eine zweite PN-ÜbergangsDiode ($D_3$) mit Erde verbunden ist, und die Basis des genannten achten Transistors ($T_8$) über einen Lastwiderstand ($R_7$) mit der Stromversorgung und der Emitter des genannten achten Transistors mit dem Kollektor des genannten zweiten Transistors ($T_5$ in Fig. 3B) verbunden sind.

12. Schmitt-Trigger-Schaltung nach Anspruch 11, dadurch gekennzeichnet, daß der zweite Transistor ($T_5$ in Fig. 3B) ferner einen Kollektor umfaßt, welcher über einen vierten Lastwiderstand ($R_4$) mit der genannten Stromversorgung verbunden ist und einen Emitter, welcher über einen Vorspannungswiderstand ($R_5$) mit Erde verbunden ist.

13. Schmitt-Trigger-Schaltung nach Anspruch 12, dadurch gekennzeichnet, daß die Ausgangsstufe ferner einen sechsten NPN-Transistor ($T_6$ in Fig. 3B) umfaßt, dessen Basis mit dem Emitter des genannten zweiten Transistors ($T_5$ in Fig. 3B), dessen Kollektor mit einem Ausgangsanschluß der genannten Schmitt-Trigger-Schaltung und dessen Emitter mit Erde verbunden sind.

Fig. 1A

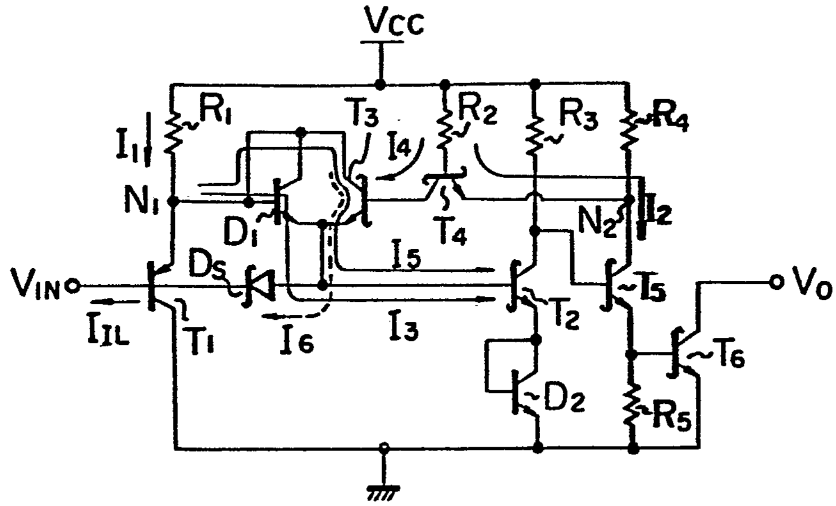
Vcc
R1
I1
T3
I4
R2
R3
R4
N1
D1
T4
N2
I2
I5
VIN
Ds
T5
Vo
IIL
T1
I6
I3
T2
T6
D2
R5

Fig. 1B

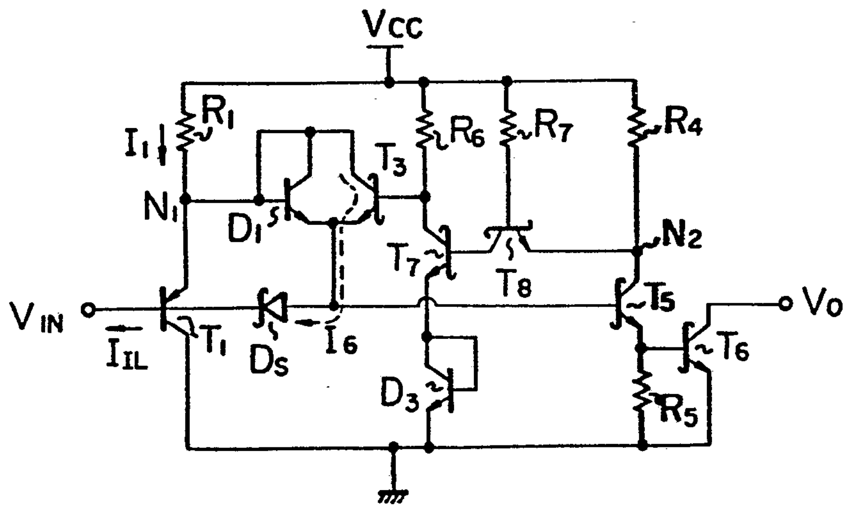
Vcc
R1
I1
R6
R7
R4
T3
N1
D1
N2
T7
T8
T5
VIN
Vo
IIL
T1
Ds
I6
T6
D3
R5

Fig. 2A

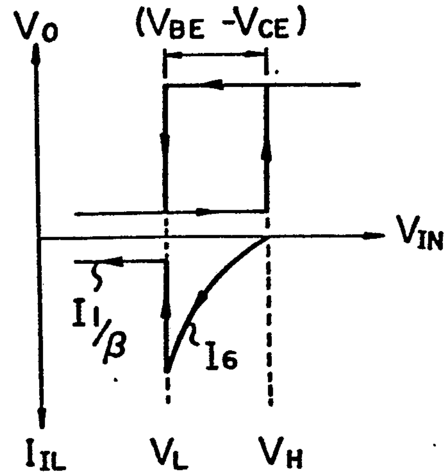


Fig. 2B

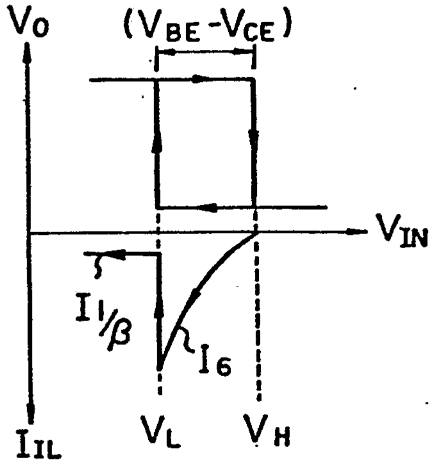


Fig. 3A

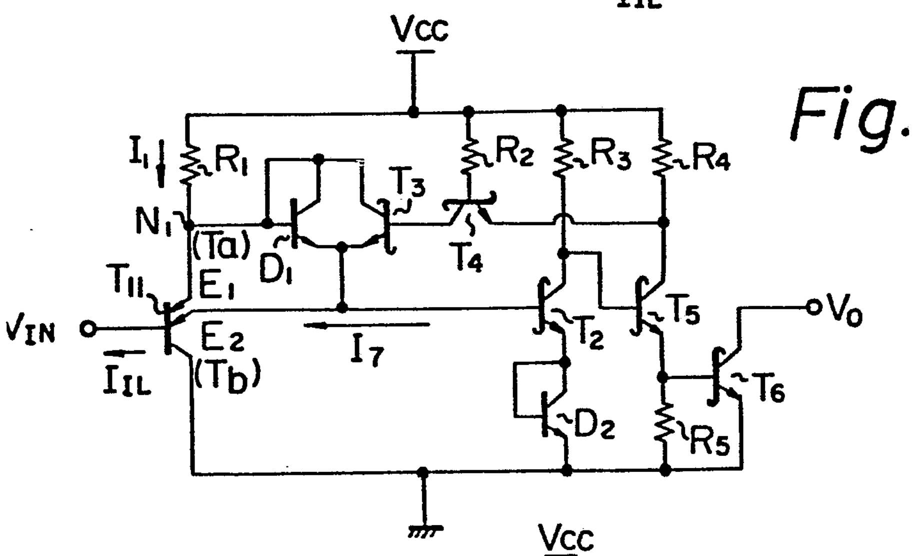


Fig. 3B

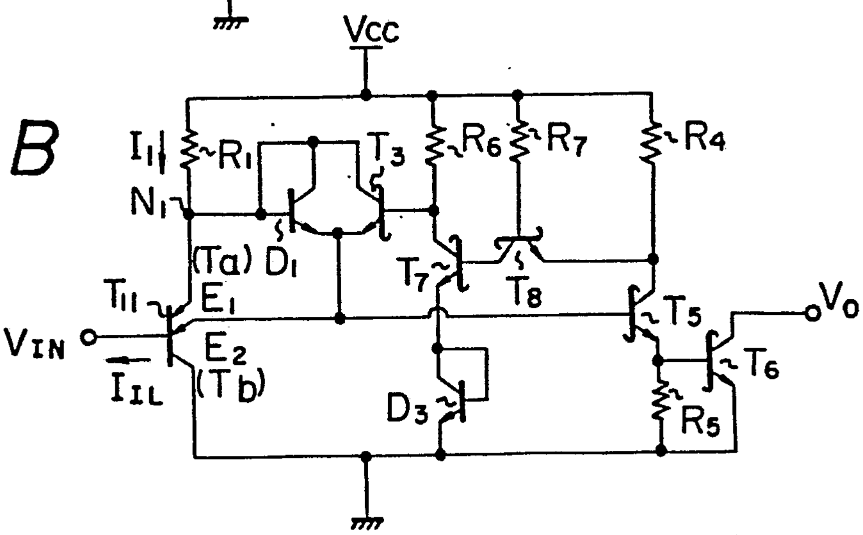

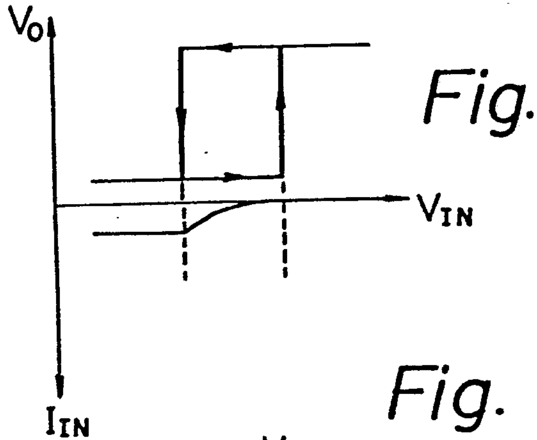


Fig. 4A

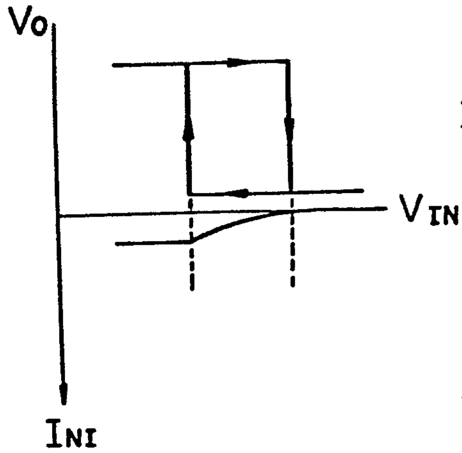


Fig. 4B

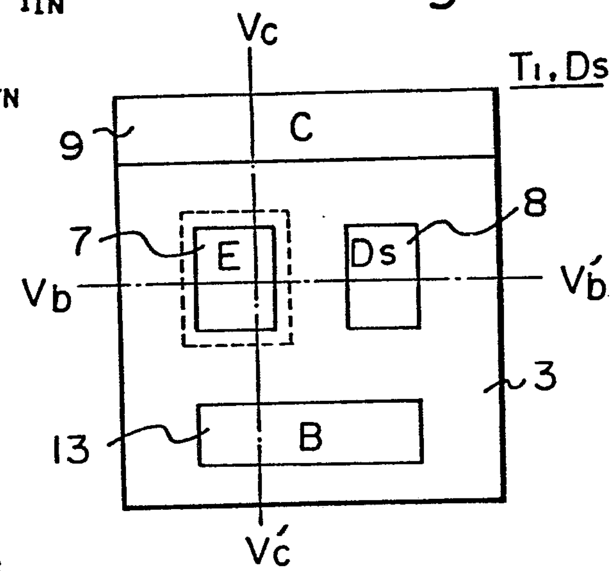


Fig. 5A

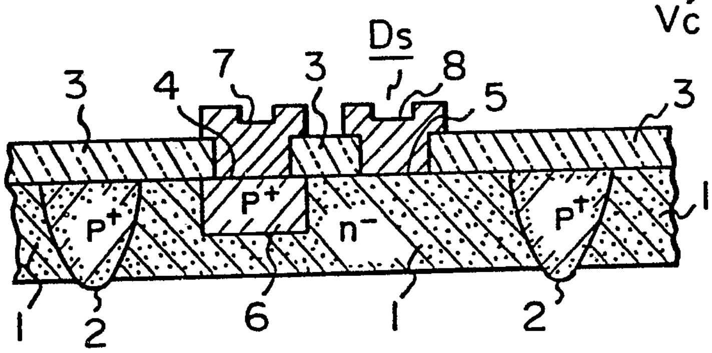


Fig. 5B

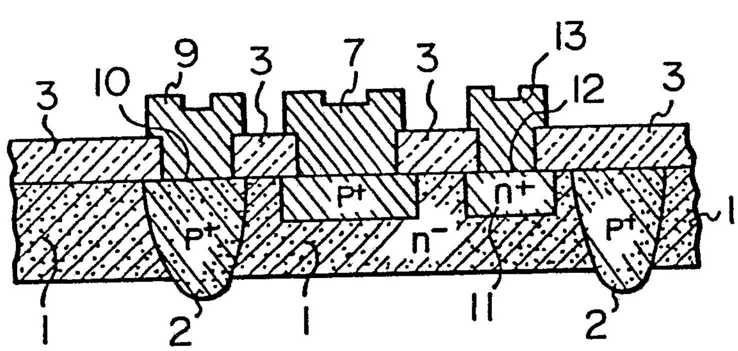


Fig. 5C

Fig. 6A

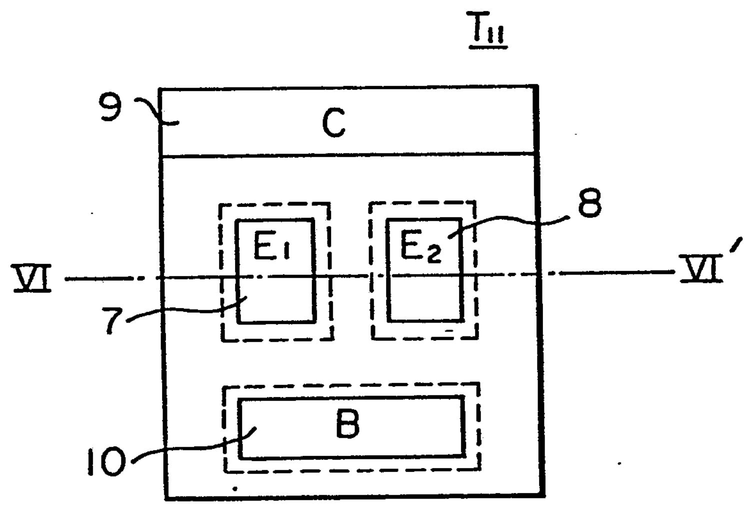


Fig. 6B